# EUROPÄISCHE PATENTSCHRIFT

(11) **EP 0 982 979 B1**
(45) Veröffentlichungstag und Bekanntmachung des Hinweises auf die Patenterteilung: **29.06.2005**
(21) Anmeldenummer: 99112500.6
(22) Anmeldetag: 01.07.1999
(51) Int. Cl.: H05K 7/14

(54) **Elektro-Gehäuse**
Electric housing
Boîtier électrique

(30) Priorität: 21.08.1998 DE 19837974
(43) Veröffentlichungstag der Anmeldung: 01.03.2000
(73) Patentinhaber: ROBERT BOSCH GMBH, 70442 Stuttgart (DE)
(72) Erfinder: Doersam, Thomas, 69488 Birkenau (DE); Krajc, Adolf, 64711 Erbach (DE)
(74) Vertreter: Thürer, Andreas

(56) Entgegenhaltungen:
- DE-A- 3 504 874
- US-A- 3 919 738
- US-A- 5 397 856

## Beschreibung

### Stand der Technik

Die Erfindung betrifft ein Elektro-Gehäuse aus elektrisch leitfähigem Material zum Einsetzen einer kaschierten Leiterplatte mit den Merkmalen des Oberbegriffs des Anspruchs 1.

Aus der US-PS 3 200 361 ist ein Rahmen für eine kaschierte Leiterplatte bekannt. Die Leiterplatte ist mit Leiterbahnen aus Kupfer kaschiert, sie wird oder ist mit elektrischen und/oder elektronischen Bauelementen bestückt, deren elektrische Anschlüsse mit den Leiterbahnen verlötet werden. Die Leiterplatte dient also zum Aufbau einer elektronischen Schaltung.

Der bekannte Rahmen weist nach innen stehende Einformungen auf. Die Einformungen sind als paarweise parallel nebeneinander angeordnete Bügel ausgebildet, die einen Schlitz zwischen sich begrenzen, in den die Leiterplatte steckbar ist. Zur Kontaktierung des Rahmens mit einer Leiterbahn, vorzugsweise einem Masseleiter, der Leiterplatte werden die Bügel mit der Leiterbahn verlötet. Die Kontaktierung des Rahmens mit einer Leiterbahn der Leiterplatte durch Löten ist aufwendig.

### Vorteile der Erfindung

Beim erfindungsgemäßen Elektro-Gehäuse mit den Merkmalen des Anspruchs 1 weist der Schlitz der Einformung mindestens eine, vorzugsweise mehrere Schirmkrallen auf, die in den Schlitz ragen und eine Schlitzbreite verkleinern. Beim Stecken der Leiterplatte in den Schlitz kratzt oder schabt sich die Schirmkralle in eine auf die Leiterplatte kaschierte Leiterbahn ein, so daß die Leiterbahn mit dem Gehäuse kontaktiert ist. Die Erfindung hat den Vorteil, daß die Kontaktierung zwischen der Leiterbahn und dem Gehäuse werkzeuglos durch das Stecken der Leiterplatte in den Schlitz der Einformung der Gehäusewand erfolgt, ein zusätzlicher Arbeitsschritt wie beispielsweise das Verlöten entfällt. Die Erfindung bewirkt eine sichere und dauerhafte Kontaktierung, sie ist schock- und vibrationsfest. Weiterer Vorteil ist, daß die Kontaktierung gasdicht ist. Die Leiterbahn ist vorzugsweise zumindest im Kontaktierbereich verzinnt, bevor die Leiterbahn in den Schlitz der Einformung der Gehäusewand gesteckt wird. Durch die Kontaktierung weist das Gehäuse dasselbe elektrische Potential wie die kontaktierte Leiterbahn auf, die kontaktierte Leiterbahn ist daher üblicherweise ein Masseleiter. Das Gehäuse schirmt auf der Leiterplatte angebrachte elektrische und elektronische Bauelemente gegen elektromagnetische Strahlung von außen ab und verhindert in umgekehrter Richtung das Austreten im Gehäuse erzeugter elektromagnetischer Strahlung aus dem Gehäuse. Die Kontaktierung kann daher als Schirm-(Shield-)Kontaktierung, die Schirmkralle auch als Shieldkralle bezeichnet werden. Die Einformung läßt sich durch Umformen wie beispielsweise Prägen, der Schlitz beispielsweise durch Stanzen, herstellen, wobei das Stanzen des Schlitzes in einem Arbeitsschritt mit dem Herstellen der Einformung erfolgen kann.

Das erfindungsgemäße Elektro-Gehäuse ist zur Aufnahme einer elektrischen und/oder elektronischen, auf einer kaschierten Leiterplatte untergebrachten Schaltung vorgesehen. Die elektrische und/oder elektronische Schaltung kann beispielsweise eine SPS (speicherprogrammierbare-)Steuerung für eine Werkzeugmaschine oder dgl. sein.

Die Unteransprüche haben vorteilhafte Ausgestaltungen und Weiterbildungen der im Hauptanspruch angegebenen Erfindung zum Gegenstand.

Gemäß Anspruch 4 ist mindestens eine Schirmkralle an jedem Rand des Schlitzes der Einformung der Gehäusewand angeordnet. Dies hat den Vorteil, daß beidseitig kaschierte Leiterplatten beidseitig kontaktiert werden. Bei einer einseitig kaschierten Leiterplatte stellt diese Ausgestaltung der Erfindung die Kontaktierung unabhängig von der Orientierung der Leiterplatte im Schlitz sicher.

### Zeichnung

Die Erfindung wird nachfolgend anhand eines in der Zeichnung dargestellten Ausführungsbeispiels näher erläutert. Es zeigen:
- Figur 1: ein erfindungsgemäßes Gehäuse in perspektivischer Darstellung,
- Figur 2: eine vergrößerte Darstellung einer Einzelheit gemäß Pfeil II in Figur 1 in Ansicht von einer Gehäuseaußenseite,
- Figur 3: die Einzelheit aus Figur 2 in perspektivischer Darstellung von einer Gehäuseinnenseite, und
- Figur 4: eine abgewandelte Ausgestaltung der Einzelheit aus Figur 2.

### Beschreibung des Ausführungsbeispiels

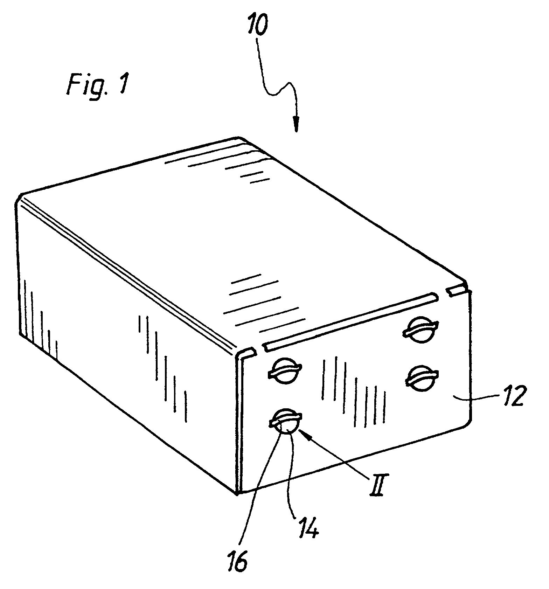

Das in Figur 1 dargestellte, erfindungsgemäße Elektro-Gehäuse 10 ist aus einem ebenen Stahlblech durch Stanzen und Biegen hergestellt. Es handelt sich um ein quaderförmiges Gehäuse 10 mit rechteckiger Grundfläche. An einer Gehäusewand, im dargestellten Ausführungsbeispiel ist es eine Stirnwand 12, weist das Gehäuse 10 vier Einformungen 14 auf, die an den Ecken eines gedachten, nicht dargestellten Rechtecks, welches parallel zur Stirnwand 12 ausgerichtet ist, innerhalb der Fläche der Stirnwand 12 angeordnet sind. Die Einformungen haben Abstand von Rändern der Stirnwand 12. Die Einformungen 14 sind durch Prägen des noch ebenen Stahlblechs vor, während oder nach dem Stanzen hergestellt. Die Einformungen 14 sind kugelförmig, sie sind in das Innere des Gehäuses 10 gewölbt.

In jeder Einformung 14 ist ein Schlitz 16 angebracht, der die Einformung 14 in der Mitte über deren gesamten Durchmesser durchsetzt. Jeder Schlitzrand 18 weist Schirmkrallen (Schieldkrallen) 20 auf. Bei den Schirmkrallen 20 handelt es sich um Zacken, die einstückig mit dem Stahlblech des Elektro-Gehäuses 10 sind und von den Rändern 18 des Schlitzes 16 in den Schlitz 16 vorstehen. Die Schirmkrallen 20 verkleinern also die Breite des Schlitzes 16 an den Stellen, an denen sich die Schirmkrallen 20 befinden. Im dargestellten Ausführungsbeispiel sind drei Schirmkrallen 20 mit Abstand nebeneinander an einem Rand 18 und drei weitere Schirmkrallen 20 diesen Schirmkrallen 20 gegenüber am anderen Rand 18 des Schlitzes 16 angeordnet. Die Schirmkrallen 20 an den beiden Rändern 18 des Schlitzes 16 können abweichend vom dargestellen Ausführungsbeispiel auch versetzt zueinander angeordnet sein.

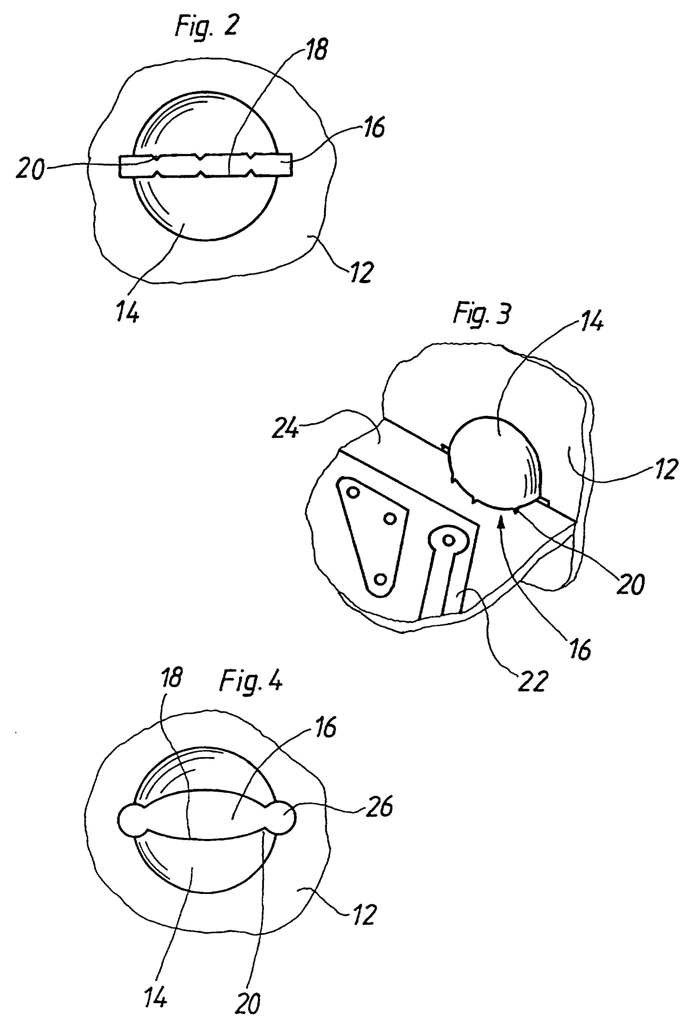

Das Elektro-Gehäuse 10 ist zum Einbau einer beispielsweise kupferkaschierten, mit elektrischen und/oder elektronischen Bauelementen bestücken Leiterplatte 22 vorgesehen. Figur 3 zeigt eine Innenseite der Stirnwand 12 im Bereich einer Einformung 14. Die Leiterplatte 22 ist mit einem ihrer Ränder in den Schlitz 16 der Einformung 14 gesteckt. Zur klaren Erkennbarkeit der Einformung 14 ist die Leiterplatte 22 in Figur 3 ohne elektrische und/oder elektronische Bauelemente gezeichnet. Der Abstand einander gegenüberstehender Schirmkrallen 20 voneinander ist geringer als eine Dicke der kaschierten Leiterplatte 22. Dadurch graben oder schaben sich die Schirmkrallen 20 beim Stecken der Leiterplatte 22 in den Schlitz 16 in eine auf die Leiterplatte 22 kaschierte Leiterbahn 24 ein, wodurch sich eine gasdichte Schirm- oder Shiedlkontaktierung des Elektro-Gehäuses 10 mit der Leiterbahn 24 ergibt. Die Leiterbahn 24 ist vorzugsweise verzinnt. Das Elektro-Gehäuse 10 bildet eine Abschirmung für die nicht dargestellten, auf der Leiterplatte 22 angebrachten elektrischen und/oder elektronischen Bauelemente (elektrische und/oder elektronische Schaltung), wobei das Elektro-Gehäuse 10 durch die Schirmkontaktierung mit den Schirmkrallen 20 dasselbe elektrische Potential wie die kontaktierte Leiterbahn 24 aufweist.

Die Leiterplatte 22 ist in die in einer Ebene befindlichen Schlitze 16 zweier Einformungen 14 der Stirnwand 12 gesteckt. Außer der Kontaktierung halten die Einformungen 14 die in ihre Schlitze 16 gesteckte Leiterplatte 22 mechanisch. Es können weitere Einformungen an weiteren Wänden des Gehäuses 10 vorgesehen sein. Die Einformungen 14, deren Schlitze 16 sich in einer Ebene befinden, dienen dem Stecken einer Leiterplatte 22, die Einformungen 14, deren Schlitze 16 sich in einer weiteren Ebene befinden, dienen dem Stecken einer weiteren Leiterplatte.

Figur 4 zeigt eine alternative Ausbildung des Schlitzes 16 einer Einformung 14. Dieser Schlitz 16 weist konkav gewölbte Ränder 18 auf. An seinen beiden Enden geht der Schlitz 16 ohne Unterbrechung in kreisrunde Ausstanzungen 26 über, deren Mittelpunkt sich auf dem Rand der Einformung 14 befindet. Am Übergang der konkaven Ränder 18 zu den kreisrunden Ausstanzungen 26 ist eine zackenförmige Schirmkralle 20 gebildet. Der Schlitz 16 der in Figur 4 dargestellten Einformung 14 weist vier Schirmkrallen 20 auf. Die in Figur 4 dargestellte Einformung 14 mit dem Schlitz 16 und den Schirmkrallen 20 hat dieselbe Funktion wie die in Figuren 1 bis 3 dargestellte und vorstehend erläuterte Einformung 14 mit dem Schlitz 16 und den Schirmkrallen 20. Zur Vermeidung von Wiederholungen wird hinsichtlich Figur 4 insoweit auf die Ausführungen zu Figuren 1 bis 3 verwiesen.

## Patentansprüche

1. Elektro-Gehäuse aus elektrisch leitfähigem Material zum Einsetzen einer kaschierten Leiterplatte, wobei eine Gehäusewand eine örtlich begrenzte Einformung nach innen aufweist, die mit einem Schlitz versehen ist, in den die Leiterplatte steckbar ist, **dadurch gekennzeichnet, daß** der Schlitz (16) eine Schirmkralle (20) aufweist, die sich beim Stecken der Leiterplatte (22) in den Schlitz (16) in die Kaschierung (24) der Leiterplatte (22) einformt.

2. Elektro-Gehäuse nach Anspruch 1, **dadurch gekennzeichnet, daß** das Gehäuse (10) aus Metall besteht.

3. Elektro-Gehäuse nach Anspruch 1, **dadurch gekennzeichnet, daß** der Schlitz (16) mehrere Schirmkrallen (20) aufweist.

4. Elektro-Gehäuse nach Anspruch 3, **dadurch gekennzeichnet, daß** die Schirmkrallen (20) an zwei Schlitzrändern (18) angeordnet sind.

5. Elektro-Gehäuse nach Anspruch 1, **dadurch gekennzeichnet, daß** das Gehäuse (10) mehrere Einformungen (14) aufweist, deren Schlitze (16) sich in einer Ebene befinden.

6. Elektro-Gehäuse nach Anspruch 1, **dadurch gekennzeichnet, daß** das Gehäuse (10) Einformungen (14) mit Schlitzen (16) in unterschiedlichen Ebenen aufweist.

7. Elektro-Gehäuse nach Anspruch 2, **dadurch gekennzeichnet, daß** das Gehäuse (10) ein Blechstanz- und Biegeteil ist.

## Claims

1. Electric housing made of an electrically conductive material for the purpose of inserting a laminated printed circuit board, a housing wall having a locally limited moulding on the inside which is provided with a slot into which the printed circuit board can be plugged, **characterized in that** the slot (16) has a shielding claw (20) which is moulded into the lamination (24) of the printed circuit board (22) when the printed circuit board (22) is plugged into the slot (16).

2. Electric housing according to Claim 1, **characterized in that** the housing (10) is made of metal.

3. Electric housing according to Claim 1, **characterized in that** the slot (16) has a plurality of shielding claws (20).

4. Electric housing according to Claim 3, **characterized in that** the shielding claws (20) are arranged at two slot edges (18).

5. Electric housing according to Claim 1, **characterized in that** the housing (10) has a plurality of mouldings (14), whose slots (16) are located on one plane.

6. Electric housing according to Claim 1, **characterized in that** the housing (10) has mouldings (14) having slots (16) on different planes.

7. Electric housing according to Claim 2, **characterized in that** the housing (10) is a stamped sheet-metal part and bent part.

## Revendications

1. Boîtier électrique en matière électro-conductrice pour loger une plaque de circuit imprimé, marouflée, une paroi du boîtier ayant une déformation localement limitée, vers l'intérieur, munie d'une fente dans laquelle s'engage la plaque de circuit,
**caractérisé en ce que**
la fente (16) comporte une griffe (20) qui lorsqu'on engage la plaque de circuit (22) dans la fente (16) s'incruste dans la doublure (24) de la plaque de circuit (22).

2. Boîtier électrique selon la revendication 1,
**caractérisé en ce que**
le boîtier (10) est en métal.

3. Boîtier électrique selon la revendication 1,
**caractérisé en ce que**
la fente (16) comporte plusieurs griffes (20).

4. Boîtier électrique selon la revendication 3,
**caractérisé en ce que**
les griffes (20) sont prévues sur deux bords (18) de fentes.

5. Boîtier électrique selon la revendication 1,
**caractérisé en ce que**
le boîtier (10) comporte plusieurs parties embouties (14) dont les fentes (16) se situent dans un plan.

6. Boîtier électrique selon la revendication 1,
**caractérisé en ce que**
le boîtier (10) comporte des parties embouties (14) avec des fentes (16) dans des plans différents.

7. Boîtier électrique selon la revendication 2,
**caractérisé en ce que**
le boîtier (10) est une pièce en tôle emboutie et cintrée.
